# EUROPEAN PATENT SPECIFICATION

(11) **EP 1 682 690 B1**
(45) Date of publication and mention of the grant of the patent: **18.01.2012**
(21) Application number: 04799400.9
(22) Date of filing: 03.11.2004
(51) Int. Cl.: C23C 14/56, C23C 14/02

(54) **APPARATUS AND METHOD FOR THE VACUUM METALLIZATION OF TEXTILE MATERIALS AND THE LIKE**
VORRICHTUNG UND VERFAHREN ZUR VAKUUMMETALLISIERUNG VON TEXTILMATERIALIEN UND DERGLEICHEN
APPAREIL ET PROCEDE POUR LA METALLISATION SOUS VIDE DE MATIERES TEXTILES ET ANALOGUES

(30) Priority: 05.11.2003 IT FI20030281
(43) Date of publication of application: 26.07.2006
(73) Proprietor: Cecchi, Emanuele, 59100 Prato (IT)
(72) Inventor: Cecchi, Emanuele, 59100 Prato (IT)
(74) Representative: Barberi, Vittorio
(86) International application number: PCT/IT2004/000603
(87) International publication number: WO 2005/045093

(56) References cited:
- EP-A- 0 512 386
- GB-A- 800 093
- GB-A- 811 263
- GB-A- 923 963
- GB-A- 1 527 893
- US-A- 2 402 269
- US-A- 3 201 275
- US-A- 4 844 009
- DATABASE WPI Section Ch, Week 198528 Derwent Publications Ltd., London, GB; Class A14, AN 1985-167293 XP002319012 & JP 60 045695 A (JAPAN TOBACCO & SALT PUBLIC) 12 March 1985 (1985-03-12)
- PATENT ABSTRACTS OF JAPAN vol. 1995, no. 07, 31 August 1995 (1995-08-31) & JP 07 090585 A (KAO CORP), 4 April 1995 (1995-04-04)

## Description

The present invention refers to an apparatus and method for the vacuum metallization of textile materials and the like. Processes are known for metallizing textiles and other surfaces by vacuum deposition of a metal coating. According to these processes, it is possible to produce textiles, in particular of synthetic origin, which acquire special characteristics related, for example, to light reflection, heat, electromagnetism, aesthetic effect, etc.

GB811263 discloses vacuum degassing of paper before metallization.

GB-A- 774 439 discloses a process for producing metallization effects on textile materials made from artificial cellulose fibres by exposing said material to an evaporated metal in a high-vacuum ambient conditions.

GB-A- 796 138 discloses a method for metallizing textile materials, in particular, those made from cellulose fibre. According to this invention, once the metal has been deposited on the textile material, the coated material is heated at a temperature exceeding 100 °C to complete the treatment.

GB-A- 1 024 943 discloses a metallization method which provides for impregnating the materials to be treated with an aqueous emulsion of a self-cross-linking acrylic copolymer or a methacrylic acid ester.

Drawbacks of the known technique relate to the possibility of processing only few types of materials, mostly textiles and knitted materials of synthetic fibres and unbeaten weave, inasmuch as the fibres of animal and vegetable nature are ill-suited for such processes owing to the water and air contents which characterize the latter; moreover, in some treatments of known type it is necessary using additives and other substances to obtain the metallization.

The object of the present invention is to overcome the above drawbacks.

This result has been achieved, according to the invention, by adopting the idea of providing a method and an apparatus having the characteristics indicated in the independent claims. Further characteristics being set forth in the dependent claims.

The advantages of the present invention include the fact that it is possible to metallize substantially any type of textile material, that it is not required using special additives, that the method meets the requirements of the industrial production, that is, it allows metallizing the textile material effectively and at a relatively high rate, also in considerable amounts.

These and other advantages and characteristics of the invention will be best understood by anyone skilled in the art from a reading of the following description in conjunction with the attached drawings given as a practical exemplification of the invention, but not to be considered in a limitative sense, wherein:
- Fig. 1 is a schematic illustration of a possible, exemplary embodiment of the present invention, with an apparatus wherein some components thereof are represented by blocks and others in simplified form;
- Fig. 2 is a view in diametral cross-section of a further possible, exemplary embodiment of the invention represented in schematic form;
- Fig. 3 is a schematic front view of a further possible, exemplary embodiment of the invention represented by a metallization machine.

Provision is made for metallizing textiles or other materials after they have been subjected to a thorough removal of water therefrom. In practice, according to the invention, the phase of metallization is preceded by a substantially total elimination of the water from the materials to be processed.

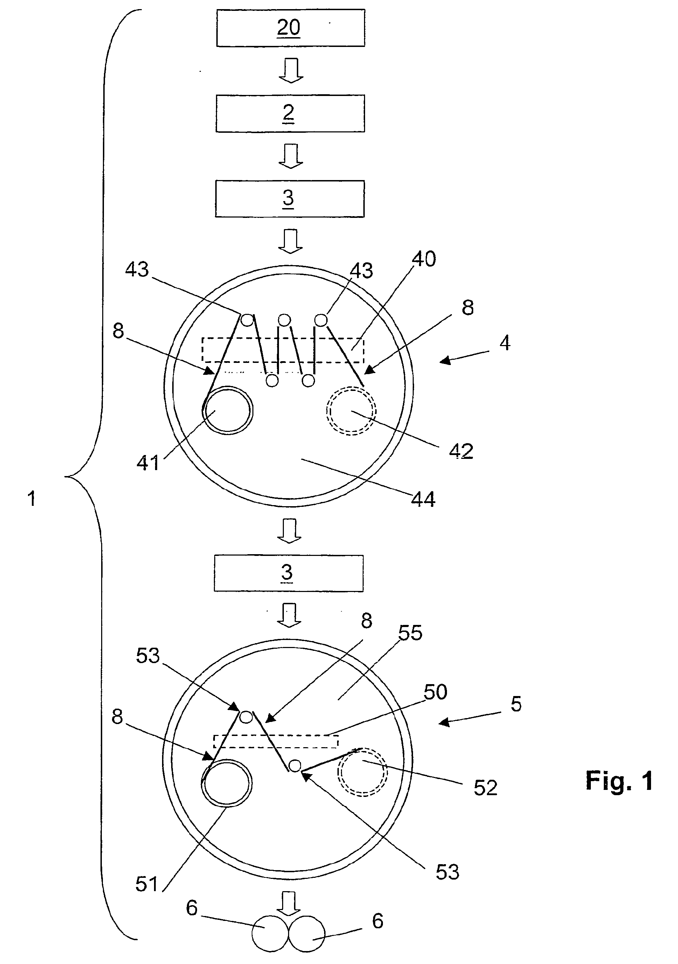

Reference is now made to the example of Fig. 1 for describing a possible metallization method and a apparatus able to implement said method.

Initially, the material to be processed is subjected to a preparation step. In particular, the preparation step provides for removing the water (for example, by transiting through a drier or rameuse), and it may be preceded, as best described later on, by a cleaning of the material to be treated (for example, by a suitable washing operation which depends on the characteristics of the material).

These two procedures (and relevant devices for implementing them) are schematically represented by the blocks 20 and 2 in Fig. 1.

Thereafter, the material (which has been washed and dehydrated) is introduced into a tight-seal container, for example within nylon wrappers and/or heating blankets. This step, also called stockage or storage in the present specification, is represented by the block 3 and will best described later on.

Following the above described step, the material may be introduced directly into a metallizing device 5, or it may be subjected beforehand to a plasma treatment (represented by the machine 4 in Fig. 1 and also described in greater detail later on) to improve the characteristics of association thereof with the metal. Between the plasma treatment process (machine 4) and the metallization (machine 5) provision may be made for a second stockage 3.

The metallization process, after passing the fabric through the metallizing machine 5, may be completed with a calendering operation, schematically represented by the rollers 6 in Fig. 1, in order to carry out a sintering process able to luster and more efficiently fixing the metal to the textile material.

In the present specification, the term "textiles" is used herein to refer also to other materials which, even if they cannot be termed as fabrics, exhibit similar characteristics for their association with the metal in view of the metallization thereof according to the invention.

As above mentioned in relation to the step of preparing the textiles (or other materials), in particular for the cleaning step (block 20), provision may be made for different treatments according to the type of textile material, as set forth in the following examples.

For the wool, wool blends, and natural fibres of animal origin, it is possible to carry out an effective scouring, by washing the textiles in either widened out or rope-like twisted condition, and then drying them. In order to improve the thorough cleaning of the textile material it is suitable to carry out one or two dry cleanings, inasmuch as a small amount of residual size or of various glues would result of damage in the metallization step. The textile material so treated is ready for the next steps. To improve the fibre-to-metal adhesion, thereby obtaining an optimal hydrophily of this type of textiles, a plasma treatment is in order, to be described later on with reference to the machine 4 of Fig. 1. For cotton, cotton blends, flax, flax blends and fibres of vegetable origin, in order to obtain an effective desizing, recourse may be made to a stockage of traditional type for cottons and to a subsequent washing operation with the fabric in widened out condition. Good results derive from a bleaching and mercerization to remove any residue possible present in the cotton and obtaining a good hydrophily of the fibre as well as some degree of white. A dry cleaning is suited for eliminating any residual fats. Optionally, in this case too the plasma treatment sensibly improves the hydrophily of the textile material and thus its bond with the metal.

For polyester, nylon blends, viscoses, acetates, rayon and other fibres of artificial origin, the process provides for a traditional washing with the fabric widened out, a drying operation and two (recommended) successive dry cleaning operations. The plasma treatment, which makes the fibre more hydrophilic, is in this case necessary.

In addition to the above mentioned materials, the present invention is applicable also in the metallization of fabrics already dyed or printed, and also of fabrics or laminates for sails in the nautical field.

In case of dyed textiles, it is sufficient to perform only one dry cleaning before the stockage.

For sail textiles containing polyesters, dacron, mylar, kevlar, carbon, nylon, etc., the process will result simplified. A dry cleaning is feasible and a calendering operation is hardly ever necessary.

In an apparatus made according to the invention, the block 20 of Fig. 1 represents, therefore, one or more washing machines able to carry out the cleaning step above described.

As for the thorough drying or dehydrating step, represented by the block 2, this is necessary because the textiles obtained after the cleaning will result hydrophilic, owing to the previous step, and because they retain a great deal of humidity owing to their own nature. Such humidity could endanger the vacuum seal of the metallizing device. For this reason, the textiles are disposed in a rameuse or drier 2 and dried under forced ventilation by means of gas burners at very high temperature, such as 170 °C, for one minute. By way of example, in a drier with an oven 20 m long, it is possible to cause the textiles transiting at a speed of 20 m/min. Advantageously, without activating the cooling of the textile material, the latter is rolled up upon its exit from the oven 2, thereby obtaining a fabric fully lacking of water and thus dry and warm, with a temperature exceeding 80-100 °C. Upon an experimental step, it is resulted of advantage for all the textiles under treatment, to dispose a sheet of well beaten synthetic fibre at the end of the roll in the course of formation to complete the last turns thereof. Once the textile material is fully rolled up, it is immediately tight-sealed, for example, with nylon, so that the dry fabric will not able to eventually draw humidity from the surrounding environment. This step can be carried out in the stockage station indicated by 3 in Fig. 1.

Alternatively (or in addition to the nylon), it is possible using a heating blanket for better maintaining warm the thus made roll. Once sealed, the roll can be handled and metallized afterwards. In practice, after having isolated the roll of material to be metallized, it is possible to immediately subjecting it to the metallization process, or it may be stored and/or transported so wrapped to perform said process later on.

As above mentioned, the plasma process can be carried out prior to the metallization. The machine 4 for the plasma process (schematically represented in Fig. 1) is provided with an internal chamber 44 wherein a vacuum is created. Inside the chamber 44, the material 8 being wound up in coil form, is disposed onto a roller 41 and, through a series of driving-out rollers 43, comes to a collecting roller 42. In its path inside the machine 4, the material 8 comes in contact with one or more devices suited for the plasma treatment, which devices are represented by the block 40 outlined by dashed line. Since the machine 4 in charge of such process is negatively affected by the humidity possibly present in the textiles to be treated, the material is introduced into said machine in a manner similar to that provided for the metallization step, that is, isolated from the ambient so as not to absorb humidity. Substantially, the plasma treatment determines a fabric-smoothing action at nanometric level by rendering the fibre much hydrophilic and thus creating more linking points for the subsequent metallization process. Upon completion of this step, the product is far more solid and effectively metallizable. After the plasma treatment, the stocking step 3 is repeated for preparing the fabric to reach the metallizing unit 5.

To load the roll of fabric onto the machine 5, the same roll is released from the heating blankets and/or the nylon and is inserted immediately into an inner chamber 55 provided in the metallizing unit. As for the proper metallization, this is a process known per se which takes place within metallizing machines (or metallizers) under vacuum conditions and through the vaporization of metals. The high vacuum is obtained in the chambers inside the metallizers by means of special powerful pumps which are known per se and therefore not to be described herein. Inside the machine 5, the material 8, which is wound up in coil form, is disposed on a roller 51 and, via a set of driving-out rollers 53 comes to a collecting roller 52. In its path inside the chamber 55, the material 8 comes in contact with one or more metallizing devices schematically represented by the block 50 with dashed line.

The material of the roll can be metallized with a variety of metals, for example, gold, silver, bronze, alluminium, copper, titanium, steel, etc.

As for the calendering step (schematically represented by the rollers 6), this is carried out, as above mentioned, in order to fix the metal to the fabric to a greater extent, especially if no plasma treatment is performed beforehand.

By way of example, a high-load, cotton-type calender may be used, for example one of 60 t, and at high-temperature, for example at 170 °C. The calender allows attaining two objects: first, to fix the metal to a higher degree by virtue of the pressure and temperature of a sintering process; second, to give the fabric a luster appearance that may be an important factor. The roll of fabric is then subjected to a load of at least 60 t and a temperature of 170-180 °C while transiting at a speed of 10-15 m/min.

A possible procedure for better fixing the metal to the fabric is the one allowing a foulard of resins to be applied thereon and drying the fabric within a drier after having carried out the metalization. In all the methods herein described, should the washing tests on the metallized material give unsatisfactory results, it would be possible using such products as primers or resins, for example, of acrylic type, to better fix the metal on the relevant supports. The application of such products may take place after the loading on the machine and the drying thereof in a traditional drier. After this treatment it is likely that the result being reached is such as to render the successive calendering useless.

When disposing the fabrics inside the metallizing unit, it may be suitable to check for an efficient vacuum tight-seal inside the chamber by carrying out (at least initially) a no-load passage of material's reeling and unreeling with the shutter of the metallizing unit being closed, that is, without supplying any metal. This precautionary measure can avoid possible damages due to an improper pressurization.

As for the example of Fig. 1, a metallization apparatus according to the invention comprises: a cleaning station 20, a thorough-drying station 2, a first stocking station 3, a plasma process station 4, a second stocking station 3, a metallization station 5, a calendering station 6. The members for moving, driving and controlling the elements above described are of a type known to those skilled in the industrial automation and, therefore, are not described in greater detail for sake of simplicity.

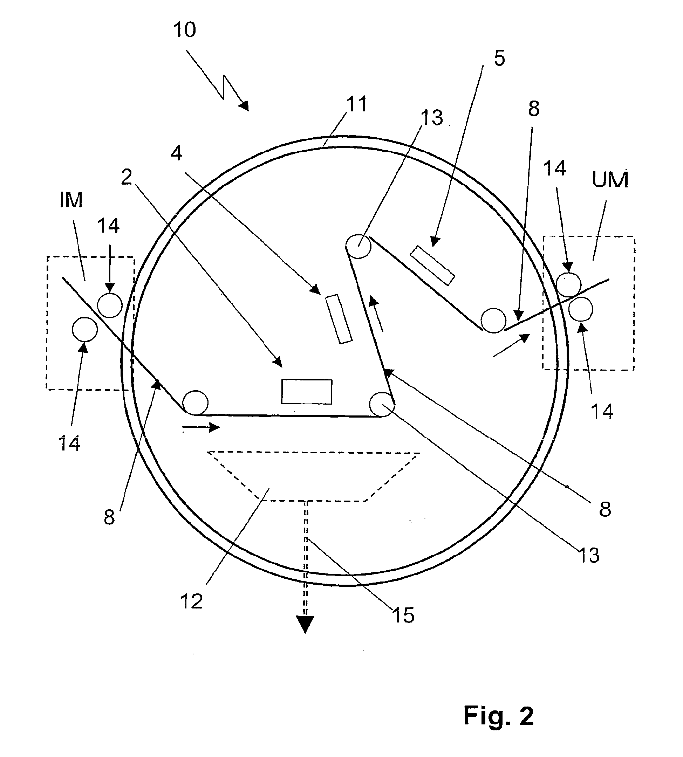

Referring now to the example of Fig. 2, a further embodiment of the apparatus provides that many of the above operations be carried out under vacuum condition inside a single machine 10 holding a plurality of operating devices.

In this embodiment, the textile material (or other material to be metallized) is dried inside the machine 10. The material 8 to be metallized, being washed beforehand, is introduced inside the chamber 11 which is kept tight-sealed. In particular, provision is made for an admission pre-chamber IM and an exit pre-chamber UM, which exhibit rollers 14 able to withstand a pressure seal. The pre-chambers IM and UM make it possible to ensure the vacuum inside the chamber 11 also during the constant transit of the material 8. Also possible is to provide a machine 10 having a plurality of cascade-like disposed chambers (not shown), at gradually increasing pressures, so as to obtain the desired pressurization.

With reference to Fig. 2, once the material 8 is introduced into the chamber 11, it is subjected to the action of the heating means 2 which may consist, for example, of an infrared device or other suitable means.

The water taken out from the material 8 is collected by a suitable removal unit (schematically represented by the hopper 12) and fed to the outside of the chamber via a sealed conduit 15 which ensures the impermeability of chamber 11.

Thereafter, the material is made to pass in correspondence of a device for plasma-treatment, schematically represented by the block 4 and, then, in correspondence of a device for the metalization treatment, schematically represented by the block 5. The whole metallization process takes place continually inside the same machine 10. It should be appreciated that also in this embodiment provision may be made for suitable means for controlling and driving the various devices. This particular embodiment allows suppressing the step of introducing the material within sealed containers. In the present instance, the above mentioned calendering operation can be carried out by the same rollers 14, or provision may be made for other means able to perform such operation also inside the chamber 11.

A further possibility offered by the present invention, and applicable to both the examples above described, provides for a particular conformation of the calendering cylinders. In practice, the cylinders can be formed with micro-engravings, made thereon by a laser, for example, which are able to produce corresponding micro-reliefs on the metallized material which give the fabric a substantially holographic conformation. The treatment with such cylinders excludes, obviously, any subsequent run within traditional calenders. In addition, depending on the material to be treated, the transit between such modified cylinders can be performed either before or after the metallization process by the members 50, 5.

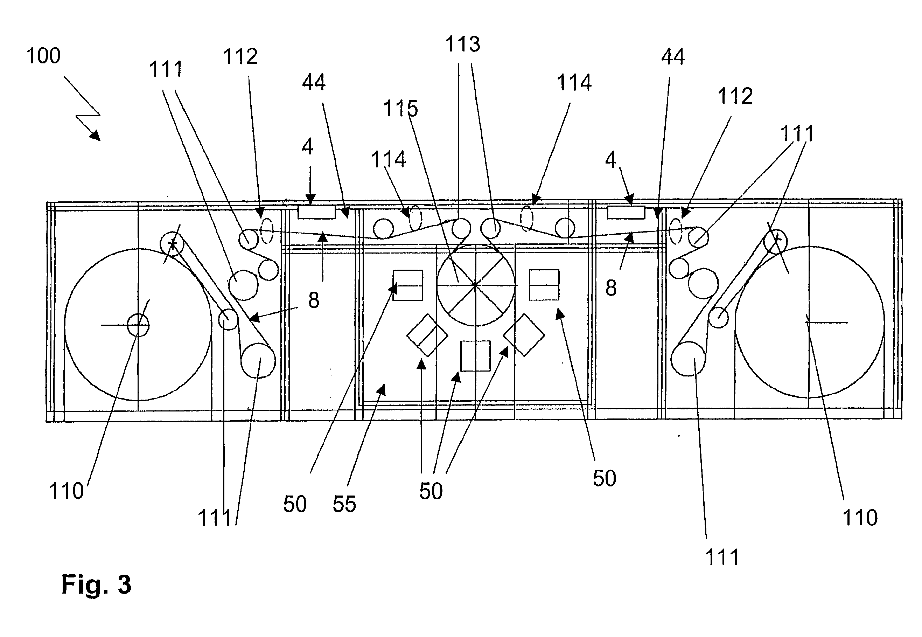

Shown schematically in Fig. 3 is a metallization machine 100. The material to be treated comes to the machine 100 already washed and dehydrated, in a way similar to what has been previously described.

The material to be treated is wound up into coils and supported by suitable rollers 110. The motorization of rollers 110 is bidirectional so as to carry out more than one treatment on the material. In practice, the material 8 is first unreeled from a roller 110, the one on the left, for example, and wound up onto the other roller 110 (the one on the right); thereafter, the material 8 is unwound from the righthand roller and wound on the left-hand roller, by following the same path but in opposite direction. The path between the two rollers 110 provides for passing the material through different treatment stations as it is guided by a plurality of driving-out rollers 111.

Advantageously, some of the driving-out rollers 111 can be heated, for example by steam.

In particular, along the path followed by the material 8, devices can be provided for stretching and/or centering the material and preventing the formation of creases or wrinkles in the fabric 8. In Fig. 3, numeral 112 refers to stretching/centering devices of so-called "dogal" type. Other dogal devices 113 of stretcher type are provided in the central region above the roller 115 of the metallization station or chamber 55, so as to stretch the fabric 8 just upstream of the chamber 55. Located on both sides of said dogal device 113 are and act two stretching devices 114 of so-called "banana" type, that is, consisting of cylinders which exhibit a curvature along their longitudinal development to better broaden the fabric 8.

During the working of the material 8, this is made to pass downstream of the first dogal device 112, into a chamber 44 which is kept under vacuum and in which there are provided and made to act plasma-treatment devices represented schematically by the block 4.

Downstream of chamber 44, the material 8 is again stretched by the devices 114 and 113 to pass then into the metallization chamber 55 (also under vacuum). In its way inside the chamber 55, the material comes in contact with one or more metallizing devices schematically represented by the blocks 50. Advantageously, the metallizing devices 50 may consist of emitters of different type so as to perform different types of operations. For example, they may be cathod-arc emitters or of so-called "sputtering" type or of electrical resistance type.

Besides being possibly of different type, the emitters 50 may also be intended for delivering different metals. In practice, it is possible either to obtain different types of operations or to metallize by different metals.

Practically, the construction details may vary in any equivalent way as far as the shape, dimensions, elements disposition, nature of the used materials are concerned, without nevertheless departing from the scope of the adopted solution idea and, thereby, remaining within the limits of the protection granted to the present patent.

## Claims

1. Method for the vacuum metallization of textile materials, of a type which provides for a metallization step in which a metal is associated, within a vacuum chamber, with the material to be metallized, **characterized in that** it comprises, prior to the metallization step, a step of removal of water from the material to be metallized performed in a drier (2) with forced ventilation performed by means of gas burners: the material so treated being kept substantially isolated from the outer environment until the metallization step.

2. Method according to claim 1, **characterized in that** the forced ventilation is performed at a temperature comprised between 130 and 210°C.

3. Method according to claim 1, **characterized in that** the forced ventilation is performed at a temperature of 170°C.

4. Method according to claim 1, **characterized in that** prior to the metallization, the material is subjected to a plasma treatment.

5. Method according to claim 1, **characterized in that** it comprises a step of calendering the material after the latter has been metallized.

6. Method according to claim 1, **characterized in that** provides for a step of covering the material to be metallized with resin.

7. Apparatus for the vacuum metallization of textile materials, of a type comprising a vacuum chamber with means to metallize the textile material, **characterized in that** it is provided with a station for the removal of water comprising a drier with forced ventilation comprising gas burners.

8. Apparatus according to claim 7 **characterized in that** it comprises a station (4) for the plasma-treatment of the material to be metallized and disposed downstream of said water-removing station (2).

9. Apparatus according to claim 7 **characterized in that** it comprises a calendering station (6) located downstream of said metallization chamber (55; 11).

10. Apparatus according to any of claims 7-9 **characterized in that** it comprises metallizing devices (50) consisting of emitters of different type so as to carry out different types of operations.

11. Apparatus according to any of claims 7-9 **characterized in that** it comprises metallizing devices (50) consisting of emitters able to deliver metals of different types.

## Patentansprüche

1. Methode zur Metallisierung von Textilmaterial unter Vakuum, auf eine Weise, welche eine Metallisierungsphase vorsieht, in der in einem Vakuumraum dem zu metallisierenden Material ein Metall beigeordnet wird, **dadurch gekennzeichnet, dass** die Methode vor der Metallisierungsphase eine Phase der Entfernung von Wasser aus dem zu metallisierenden Material vorsieht, die von einem Trockner (2) mit Zwangsbelüftung, die durch einen Gasbrenner erfolgt, durchgeführt wird: Das auf diese Weise behandelte Material bleibt bis zur Metallisierungsphase im Wesentlichen von der äußeren Umgebung isoliert.

2. Methode nach Anspruch 1, **dadurch gekennzeichnet, dass** die Zwangsbelüftung bei einer Temperatur zwischen 130°C und 210 °C erfolgt.

3. Methode nach Anspruch 1, **dadurch gekennzeichnet, dass** die Zwangsbelüftung bei einer Temperatur von 170 °C erfolgt.

4. Methode nach Anspruch 1, **dadurch gekennzeichnet, dass** das Material vor der Metallisierung einer Plasmabehandlung unterzogen wird

5. Methode nach Anspruch 1, **dadurch gekennzeichnet, dass** diese ein Phase des Kalandrierens des Materials vorsieht, nachdem dieses metallisiert wurde.

6. Methode nach Anspruch 1, **dadurch gekennzeichnet, dass** diese eine Phase für die Verkleidung des zu metallisierenden Materials mit Harz vorsieht.

7. Apparatur zur Metallisierung von Textilmaterial unter Vakuum, auf eine Weise, die einen Vakuumraum mit Mitteln für die Metallisierung von Textilmaterial enthält, **dadurch gekennzeichnet, dass** dieser Raum eine Station zur Entfernung von Wasser vorsieht, die einen Trockner mit Zwangsbelüftung vorsieht, der einen Gasbrenner enthält.

8. Apparatur nach Anspruch 7, **dadurch gekennzeichnet, dass** sie eine Station (4) für die Plasmabehandlung des zu metallisierenden Materials vorsieht und sich unterhalb der besagten Station zur Wasserentfernung (2) befindet.

9. Apparatur nach Anspruch 7, **dadurch gekennzeichnet, dass** diese eine Station zum Kalendrieren (6) umfasst, die sich unterhalb des besagten Raums zur Metallisierung (55; 11) befindet.

10. Apparatur nach jedem der Ansprüche 7-9, **dadurch gekennzeichnet, dass** diese Vorrichtungen zur Metallisierung (50) umfasst, die aus Emittenten verschiedener Art bestehen, so dass verschiedenen Tätigkeiten durchgeführt werden.

11. Apparatur nach jedem der Ansprüche 7-9, **dadurch gekennzeichnet, dass** diese Vorrichtungen zur Metallisierung (50) umfasst, die aus Emittenten bestehen, die imstande sind, Metalle verschiedenen Ursprungs zur Verfügung zu stellen.

## Revendications

1. Procédé pour la métallisation sous vide de matières textiles, d'un type qui prévoit une étape de métallisation dans laquelle un métal est associé, dans une chambre à vide, avec le matériau à métalliser, **caractérisé en ce qu'**il comprend, avant l'étape de métallisation, une étape d'élimination de l'eau du matériau à métalliser réalisée dans un séchoir (2) avec ventilation forcée réalisée au moyen de brûleurs à gaz: le matériau ainsi traité étant maintenue sensiblement isolé de l'environnement extérieur jusqu'à l'étape métallisation.

2. Procédé selon la revendication 1, **caractérisé en ce que** la ventilation forcée est effectuée à une température comprise entre 130 et 210 ° C.

3. Procédé selon la revendication 1, **caractérisé en ce que** la ventilation forcée est effectuée à une température de 170 ° C.

4. Procédé selon la revendication 1, **caractérisé en ce que** préalablement à la métallisation, le matériau est soumis à un traitement au plasma.

5. Procédé selon la revendication 1, **caractérisé en ce qu'**il comprend une étape de calandrage du matériau après que ce dernier a été métallisé.

6. Procédé selon la revendication 1, **caractérisé en ce que** prévoit une étape de recouvrement du matériau à métallisé avec de la résine.

7. Appareil pour la métallisation sous vide de matières textiles, du type comprenant une chambre à vide avec des moyens pour métalliser la matière textile, **caractérisé en ce qu'**il est fourni avec une station pour l'élimination de l'eau comprenant un séchoir à ventilation forcée comprenant des brûleurs à gaz.

8. Appareil selon la revendication 7 **caractérisé en ce qu'**il comprend une station (4) pour le plasma-traitement du matériau à métalliser et située en aval de ladite pour l'élimination de l'eau (2).

9. Appareil selon la revendication 7 **caractérisé en ce qu'**il comprend une station de calandrage (6) située en aval de ladite chambre de métallisation (55, 11).

10. Appareil selon l'une quelconque des revendications 7-9 **caractérisé en ce qu'**il comprend des dispositifs de métallisation (50) composé d'émetteurs de type différent afin d'effectuer différents types d'opérations.

11. Appareil selon l'une quelconque des revendications 7-9 **caractérisé en ce qu'**il comprend des dispositifs de métallisation (50) composé d'émetteurs capables de livrer les métaux de différents types.
